# EUROPÄISCHE PATENTSCHRIFT

(11) **EP 0 374 408 B1**
(45) Veröffentlichungstag und Bekanntmachung des Hinweises auf die Patenterteilung: **23.03.1994**
(21) Anmeldenummer: 89119223.9
(22) Anmeldetag: 17.10.1989
(51) Int. Cl.: H01L 29/80, H01L 29/54

(54) **Feldeffekttransistor und Verfahren zum Herstellen eines Feldeffenkttransistors**
Field-effect transistor and method of producing the same
Transistor à effet de champ et sa méthode de fabrication

(30) Priorität: 20.12.1988 DE 3842863
(43) Veröffentlichungstag der Anmeldung: 27.06.1990
(73) Patentinhaber: FRAUNHOFER-GESELLSCHAFT ZUR FÖRDERUNG DER ANGEWANDTEN FORSCHUNG E.V., 80636 München (DE)
(72) Erfinder: Wennekers, Peter, D-7800 Freiburg (DE)

(56) Entgegenhaltungen:
- GB-A- 2 024 506
- JAPANESE JOURNAL OF APPLIED PHYSICS. vol. 27, no. 9, September 1988, TOKYO JP Seiten 1718 - 1722; T.NITTONO ET.EL: "NON-ALLOYED OHMIC CONTACTS TO N-GAAS USING COMPOSITIONALLY GRADED INxGA1-xAS LAYERS"

## Beschreibung

Die Erfindung betrifft einen Feldeffekttransistor mit einer Schichtenfolge aus einem halbisolierenden Substrat, aus einer epitaktisch aufgewachsenen undotierten Gallium-Aluminium-Arsenid- oder Gallium-Arsenid-Buffer-Schicht und aus einer Kanalschicht, aus einem gut leitenden dotierten Gallium-Arsenid, auf der für die Sourceelektrode und Drainelektrode im seitlichen Abstand voneinander metallisch beschichtete Gallium-Arsenid-Deckschichtstreifen aufgebracht sind, zwischen denen sich als Gateelektrode ein unmittelbar auf der Kanalschicht aufgetragener Metallstreifen befindet.

Weiterhin betrifft die Erfindung ein Verfahren zum Herstellen eines Feldeffekttransistors, bei dem auf einer als Substrat dienenden Gallium-Arsenid-Scheibe epitaktisch eine Buffer-Schicht aus Gallium-Arsenid oder Gallium-Aluminium-Arsenid und anschließend epitaktisch eine leitende Kanalschicht aus mit Silizium dotiertem Gallium-Arsenid aufgebracht wird, bevor für die Source- und Drainelektroden eine Deckschicht aus gut leitendem, dotiertem Gallium-Arsenid mit einer strukturierten metallischen Aufdampfung erzeugt wird, wobei die Deckschicht zwischen der Source- und der Drainelektrode vor dem Aufbringen der Gateelektrode bis zur Kanalschicht abgeätzt wird.

Ein derartiger Gallium-Arsenid-Heterojunction-Feldeffekttransistor sowie ein derartiges Verfahren zu seiner Herstellung sind bekannt, wobei das Aufdampfen von Nickel, Gold und Germanium für die Source-Drain-Kontakte von einem Legierungsschritt gefolgt wird, bei dem Temperaturen um etwa 400° Celsius eingesetzt werden. Diese Behandlung erfolgt in einem Ofen und führt dazu, daß die Metallschicht in das Gallium-Arsenid einlegiert wird. Dabei schmilzt die Metallschicht auf, so daß sich die Elektrode seitlich verbreitet und eine ungleichmäßige Ausbildung der Elektrodenkanten erfolgt. Dadurch variiert der Seitliche Abstand zwischen dem Source- und dem Drain-Kontakt längs der parallel verlaufenden Kontaktbahn.

Die Feldstärke im stromdurchflossenen Feldeffekttransistor hat den größten Wert am Ort des geringsten Kontaktabstands. Die Stromlinien zwischen den Kontakten konzentrieren sich auf diesen Ort, wodurch der Kontakt dort thermisch stark belastet und leicht zerstört wird. Ein weiterer Nachteil besteht darin, daß das Einlegieren der Metallschicht nicht überall gleichmäßig in der Elektrodenfläche erfolgt. Dadurch ändert sich der Kontaktwiderstand örtlich. Der Stromfluß konzentriert sich auf die Gebiete des geringsten Kontaktwiderstandes, wodurch der Kontakt thermisch leicht überlastet werden kann. Durch die Schwankungen des Kontaktwiderstandes in der Elektrodenfläche, ist der mittlere Kontaktwiderstand größer als dies bei einem homogenen, aber schwierig zu erreichenden Einlegieren möglich wäre. Durch den größeren Kontaktwiderstand wird ein stärkeres Rauschen des Feldeffekttransistors verursacht.

Man hat bereits versucht, den Einlegiervorgang dadurch zu vermeiden, daß die Gallium-Arsenid-Deckschicht mit Silizium extrem hoch dotiert wird, wie in ELECTRONICS LETTERS, Vol. 22, No. 10, Seiten 510 bis 512 in dem Artikel "First successful fabrications of high-performance all-refractory-metal (Ta-Au) GaAs FET using very highly doped N⁺-layers and nonalloyed ohmic contacts" beschrieben ist. Bei dem bekannten Verfahren bilden sich jedoch wegen der hohen Siliziumdotierung in der Gallium-Arsenid-Deckschicht ovale Defekte aus.

Kirchner et al beschreiben in dem Aufsatz "Low-resistance nonalloyed ohmic contacts to Si-doped molecular beam epitaxial GaAs", Appl. Phys. Lett. 47 (1), 1. Juli 1985, Seiten 26 bis 28, daß die Elektronenkonzentration im Gallium-Arsenid als Folge einer Hochdotierung mit Silizium eine maximale Konzentration erreicht, die den erreichbaren Kontaktwiderstand begrenzt

Ein weiteres Beispiel für Source-/Drainkontakte für GaAs-FETs findet sich in GB-A-2 024 506.

Der Erfindung liegt die Aufgabe zugrunde, einen rauscharmen, gut reproduzierbaren Feldeffekttransistor zu schaffen, für dessen Herstellung keine hohe Umgebungstemperaturen erforderlich machende Legierungsschritte notwendig sind.

Diese Aufgabe wird bei einem Feldeffekttransistor der eingangs genannten Art dadurch gelöst, daß zwischen der Kanalschicht und den Gallium-Arsenid-Deckschichtstreifen der Source- und der Drainelektrode jeweils eine Kontakt vermittelnde Zwischenschicht aus einem Lanthanid-Arsenid vorgesehen ist, und daß die metallischen Beschichtungen der Source- und Drainelektroden durch eine aufgedampfte, nichtlegierte Metallschicht gebildet sind.

Bei einem Verfahren zum Herstellen eines Feldeffekttransistors wird die Aufgabe dadurch gelöst, daß nach dem Aufwachsen der Kanalschicht und vor dem Aufbringen der Deckschicht eine monokristalline, epitaktische Lanthanid-Arsenid-Schicht als Kontakt vermittelnde Schicht erzeugt wird, daß auf die Deckschicht metallische Kontaktstreifen als Source- und Drain-Kontakt aufgedampft werden, daß in einem ersten Ätzschritt die Deckschicht zwischen den Source- und Drain-Kontakten und in einem zweiten Ätzschritt die Lanthanid-Arsenid-Schicht zwischen den Source- und Drain-Kontakten weggeätzt wird.

Bei einem vorteilhaften Ausführungsbeispiel der Erfindung besteht die Lanthanid-Arsenid-Schicht aus einer 3 - 5 nm starken monokristallinen, epitaktischen Erbium-Arsenid-Schicht, die sehr gut leitend ist. Die aufgedampfte Metallschicht besteht aus Nickel und kann vor dem Anbringen der Kontaktdrähte mit einer Goldbeschichtung versehen werden.

Bei dem Verfahren zur Herstellung des Feldeffekttransistors werden die Arsenid-Schichten vorzugsweise in einer Molekularstrahl-Epitaxieanlage und die metallischen Kontaktstreifen für die Source- und Drainelektroden vorzugsweise in einer Metallaufdampfanlage ohne Legierungsprozeß aufgebracht. Bei dem ersten Ätzschritt wird vorzugsweise eine alkalische Ätze mit Ammoniumhydroxyd und Wasserstoffsuperoxyd verwendet, da diese Ätze selektiv auf Erbium-Arsenid stoppt.

Beim zweiten Ätzschritt zum Entfernen der Erbium-Arsenid-Schicht ist es zweckmäßig, Salzsäure zu verwenden, da diese selektiv auf der Kanalschicht aus Gallium-Arsenid stoppt.

Nachfolgend wird die Erfindung anhand der Zeichnung näher beschrieben. Es zeigen:
- **Fig. 1**: in einer nicht maßstäblichen Ansicht einen Ausschnitt aus einer mit mehreren Schichten beschichteten Gallium-Arsenid-Scheibe zur Herstellung eines erfindungsgemäßen Feldeffektransistors,
- **Fig. 2**: die Gallium-Arsenid-Scheibe gemäß Fig. 1 nach dem Aufbringen zweier metallischer Kontaktstreifen als Source- und Drain-Kontakte,
- **Fig. 3**: die Gallium-Arsenid-Scheibe gemäß Fig. 2 nach einem ersten Ätzschritt,
- **Fig. 4**: die Gallium-Arsenid-Scheibe nach einem zweiten Ätzschritt,
- **Fig. 5**: die Gallium-Arsenid-Scheibe gemäß Fig. 4 nach dem Aufdampfen eines schmalen Gate-Kontakt-Metallstreifens aus Titan und
- **Fig. 6**: den erfindungsgemäßen Feldeffekttransistor in einer schematischen perspektivischen Ansicht.

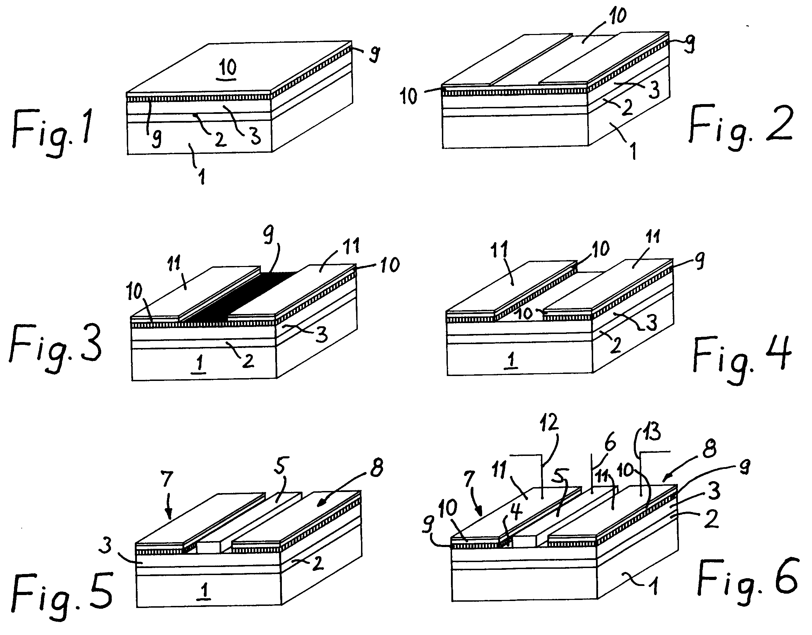

Der durch die Fig. 1 bis 5 veranschaulichte Herstellungsprozeß dient zum Herstellen des in Fig. 6 dargestellten Gallium-Arsenid-Heterojunction-Feldeffekttransistors. Selbstverständlich ist die Zeichnung nicht maßstäblich, da die verschiedenen Schichten des Feldeffekttransistors um ein Vielfaches dünner als deren Längen und Breiten sind.

Der in Fig. 6 dargestellte Feldeffekttransistor verfügt über ein halbisolierendes Gallium-Arsenid-Substrat 1, das auf seiner Unterseite mit einer nicht dargestellten Metallbeschichtung versehen sein kann. Auf dem Substrat 1 aus halbisolierendem Gallium-Arsenid befindet sich eine epitaktisch aufgewachsene monokristalline undotierte Buffer-Schicht 2 aus Gallium-Arsenid oder Gallium-Aluminium-Arsenid. Die Dicke der Buffer-Schicht 2 beträgt 100 bis 200 nm.

Als dritte Schicht in der Schichtenfolge des Feldeffekttransistors folgt auf der Buffer-Schicht 2 eine Kanalschicht 3, deren Dicke 50 nm bis 150 nm beträgt. Die Kanalschicht 3 besteht aus mit Silizium dotierten epitaktisch aufgewachsenen monokristallinen Gallium-Arsenid, das gut Elektronen leitend ist.

Entlang der Oberfläche 4 der Kanalschicht 3 erstreckt sich ein Metallstreifen 5 aus Titan oder Wolfram, der die Gateelektrode dem Feldeffekttransistors bildet und der mit einem Kontaktdraht 6 für den Gateanschluß verbunden ist.

Parallel zu dem als Gateelektrode dienenden Metallstreifen 5 erstrecken sich in Fig. 6, links eine Sourceelektrode 7 und rechts in Fig. 6 eine Drainelektrode 8, deren Schichtenfolgen identisch sind.

Die Sourceelektrode 7 und die Drainelektrode 8 verfügen jeweils über eine Kontakt vermittelnde Zwischenschicht 9 mit einer Dicke von 3 bis 5 nm. Die Zwischenschicht 9 besteht aus einer sehr gut leitenden monokristallin aufgewachsenen epitaktischen Lanthanid-Arsenid-Schicht, insbesondere einer Schicht aus Erbium-Arsenid.

Die Zwischenschichten 9 der Sourceelektrode 7 und der Drainelektrode 8 sind jeweils als parallel verlaufende Streifen ausgebildet, die sich parallel zum Metallstreifen 5 der Gateelektrode erstrecken. Die Zwischenschichten 9 sind jeweils mit einer sehr dünnen Deckschicht 10 mit einer Stärke von etwa 50 nm überzogen, die als Schutz für die Zwischenschicht 9, insbesondere aus Erbium-Arsenid dient. Die Deckschicht 10 besteht aus monokristallinem epitaktisch aufgewachsenen Gallium-Arsenid, das mit Silizium dotiert ist und leitend ist.

Die von der Zwischenschicht 9 der Sourceelektrode 7 und der Drainelektrode 8 wegweisende Oberseite der Deckschicht 10 ist mit einer Nickelschicht 11 versehen, deren Oberseite mit Gold überzogen sein kann.

An der Sourceelektrode 7 ist ein Source-Kontaktdraht 12 angeschlossen. Entsprechend ist ein Drain-Kontaktdraht 13 mit der Oberseite der gegebenenfalls vergoldeten Nickelschicht 11 der Drainelektrode 8 verbunden. Die Nickelschicht 11 bildet auf der Sourceelektrode 7 und der Drainelektrode 8 jeweils aufgedampfte parallel verlaufende Kontaktbahnen, die ohne einen Legierungsschritt aufgebracht worden sind. Daher handelt es sich bei der Sourceelektrode 7 und der Drainelektrode 8 um nichtlegierte Source-Drain-Kontakte.

Der oben beschriebene Gallium-Arsenid-Feldeffekttransistor läßt sich mit seinen ohmschen Kontakten sehr einfach und präzise herstellen.

Um die in Fig. 1 in ihrer Dicke vergrößert dargestellte Scheibe zu erzeugen, wird eine ebene Gallium-Arsenid-Scheibe, die das halbisolierende Gallium-Arsenid-Substrat 1 des fertigen Feldtransistors bildet, in einer Molekularstrahl-Epitaxieanlage auf einem beheizten Scheibenhalter im Vakuum auf 550 bis 600° aufgeheizt. In der in der Zeichnung nicht dargestellten Molekularstrahl-Epitaxieanlage befinden sich fünf Tiegel, die jeweils mit Arsen, Gallium, Aluminium, Silizium und einem Lanthanid, insbesondere Erbium gefüllt sind. Durch Öffnen der Deckel der Tiegel und Heizen des Tiegelinhalts werden Dämpfe erzeugt, die an der Oberfläche des Substrates 1 kondensieren.

In einem ersten Schritt werden der Arsentiegel und der Galliumtiegel gegebenenfalls zusammen mit einem Aluminiumtiegel bei geöffnetem Deckel erhitzt. Dadurch bildet sich durch Kondensation auf der Oberfläche des Substrates 1 eine monokristalline Gallium-Arsenid-Schicht oder Gallium-Aluminium-Arsenid-Schicht, die beim fertigen Transistor die Buffer-Schicht 2 bildet.

Zum Herstellen der Kanalschicht 3 werden der Arsentiegel, der Galliumtiegel und der Siliziumtiegel bei jeweils geöffnetem Deckel erhitzt. Die Siliziumatome machen die Kanalschicht 3 elektrisch leitend. Durch die Wahl der Temperatur des Silizium-Ofens wird die elektrische Leitfähigkeit der Kanalschicht 3 eingestellt. Die Dicke der Kanalschicht 3 wird durch die Öffnungszeit des Deckels vom Galliumtiegel bestimmt. Nachdem die gewünschte Dicke der Kanalschicht 3 von etwa 50 nm bis 150 nm erreicht ist, werden der Silizium- und dann der Galliumtiegel geschlossen. Es wird dann der Erbiumtiegel geöffnet, wobei das Erbium langsam verdampft. Arsen- und Erbiumdampf kristallisieren monokristallin auf der Kanalschicht 3 und bilden eine epitaktische Erbium-Arsenid-Schicht, die beim fertigen Feldeffekttransistor als Zwischenschicht 9 das Erstellen nichtlegierter Source-Drain-Kontakte gestattet. Die Wachstumsgeschwindigkeit wird durch die Temperatur des Erbiumtiegels eingestellt. Nach dem Aufwachsen der 3 bis 5 nm dicken monokristallinen Erbium-Arsenid-Schicht wird der Erbiumtiegel geschlossen.

Anschließend wird zuerst der Galliumtiegel und dann der Siliziumtiegel geöffnet. Dabei wird eine sehr dünne elektrisch leitende Gallium-Arsenid-Schicht aufgewachsen, die die Deckschicht 10 des Feldeffekttransistors bildet. Die Deckschicht 10 wächst monokristallin epitaktisch auf der monokristallinen Zwischenschicht 9 auf. Die Deckschicht 10 dient zum Schutz der Zwischenschicht 9 aus Erbium-Arsenid.

In einem nächsten Prozeßschritt wird die in Fig. 1 dargestellte Scheibe aus der Molekularstrahl-Epitaxieanlage entfernt. In einer Metall-Aufdampfanlage werden auf der Deckschicht 10 zwei parallel verlaufende metallische Kontaktstreifen einer Nickelschicht 11 als Source- und Drain-Kontakt aufgedampft. Dabei ergibt sich die in Fig. 2 dargestellte Struktur. Der zwischen den beiden durch die Nickelschicht 11 gebildeten metallischen Kontaktstreifen freiliegende Bereich der Deckschicht 10 aus Gallium-Arsenid wird mit einer alkalischen Ätze abgeätzt. Die Ätze enthält Ammoniumhydroxyd und Wasserstoffsuperoxyd. Die Ätze stoppt selektiv auf der Zwischenschicht aus Erbium-Arsenid. Es ergibt sich dann die in Fig. 3 dargestellte Struktur.

In Fig. 4 erkennt man einen weiteren Zwischenschritt zur Herstellung des Feldeffekttransistors. Ausgehend von dem in Fig. 3 dargestellten Zwischenschritt wird die Zwischenschicht 9 aus Erbium-Arsenid in einer sauren Ätze in dem Bereich zwischen den metallischen Kontaktstreifen der Nickelschicht 11 entfernt. Die Ätze enthält Clorwasserstoff. Eine derartige Ätze stoppt selektiv auf der Kanalschicht 3 aus dotiertem Gallium-Arsenid.

Durch Aufdampfen eines schmalen Metallstreifens 5 entsprechend Fig. 5 zwischen den beiden Kontaktstreifen aus der Nickelschicht 11 wird der Gate-Kontakt des Feldeffekttransistors erzeugt. Als Material zum Aufdampfen des Metallstreifens 5 wird Titan oder Wolfram verwendet.

In dem letzten in der Zeichnung dargestellten Herstellungsschritt werden der Metallstreifen 5 und die Kontaktstreifen aus der Nickelschicht 11 mit dem Source-Kontaktdraht 12, dem Drain-Kontaktdraht 13 und dem Kontaktdraht 6 versehen. Fig. 6 zeigt den bereits beschriebenen Feldeffekttransistor mit nichtlegierten ohmschen Source- und Drain-Kontakten.

## Patentansprüche

1. Feldeffektransistor mit einer Schichtenfolge aus aus einem halbisolierenden Substrat, aus einer epitaktisch aufgewachsenen undotierten Gallium-Aluminium-Arsenid- oder Gallium-Arsenid-Buffer-Schicht und aus einer Kanalschicht aus einem gut leitenden dotierten Gallium-Arsenid, auf der für die Sourceelektrode und Drainelektrode im seitlichen Abstand voneinander metallisch beschichtete Gallium-Arsenid-Deckschichtstreifen aufgebracht sind, zwischen denen sich als Gateelektrode ein unmittelbar auf der Kanalschicht aufgetragener Metallstreifen befindet, **dadurch gekennzeichnet,** daß zwischen der Kanalschicht (3) und den Gallium-Arsenid-Deckschichtstreifen (10) der Source- und der Drainelektrode (7, 8) jeweils eine Kontakt vermittelnde Zwischenschicht (9) aus einem Lanthanid-Arsenid vorgesehen ist, und daß die metallischen Beschichtungen der Source- und Drainelektroden (7, 8) durch eine aufgedampfte, nichtlegierte Metallschicht (11) gebildet sind.

2. Feldeffekttransistor nach Anspruch 1, **dadurch gekennzeichnet,** daß die aufgedampfte, nichtlegierte Metallschicht aus einer Nickelschicht (11) besteht.

3. Feldeffekttransistor nach Anspruch 2, dadurch gekennzeichnet , daß die Nickelschicht (11) mit einer aufgedampften Goldschicht überzogen ist, an der die Kontaktdrähte (12, 13) für die Source- und Drainelektrode (7, 8) befestigt sind.

4. Feldeffekttransistor nach einem der vorstehenden Ansprüche, **dadurch gekennzeichnet,** daß die Lanthanid-Schicht (9) eine Erbium-Arsenid-Schicht oder Ytterbium-Arsenid-Schicht ist.

5. Verfahren zum Herstellen eines Feldeffekttransistors, bei dem auf eine als Substrat dienenden Gallium-Arsenid-Scheibe epitaktisch eine Buffer-Schicht aus Gallium-Arsenid oder Gallium-Aluminium-Arsenid und anschließend epitaktisch eine leitende Kanalschicht aus mit Silizium dotiertem Gallium-Arsenid aufgebracht wird, bevor für die Source- und Drainelektroden eine Deckschicht aus gut leitendem, dotiertem Gallium-Arsenid mit einer strukturierten metallischen Aufdampfung erzeugt wird, wobei die Deckschicht zwischen der Source- und der Drainelektrode vor dem Aufbringen der Gateelektrode bis zur Kanalschicht abgeätzt wird, **dadurch gekennzeichnet,** daß nach dem Aufwachsen der Kanalschicht und vor dem Aufbringen der Deckschicht eine monokristalline, epitaktische Lanthanid-Arsenid-Schicht als Kontakt vermittelnde Schicht erzeugt wird, daß auf die Deckschicht metallische Kontaktstreifen als Source- und Drain-Kontakt aufgedampft werden, daß in einem ersten Ätzschritt die Deckschicht zwischen den Source- und Drain-Kontakten und in einem zweiten Ätzschritt die Lanthanid-Arsenid-Schicht zwischen den Source- und Drain-Kontakten weggeätzt wird.

6. Verfahren nach Anspruch 5, **dadurch gekennzeichnet,** daß die Arsenid-Schichten in einer Molekularstrahl-Epitaxieanlage und die metallischen Kontaktstreifen für die Source- und Drainelektroden in einer Metallaufdampfanlage ohne Legierungsprozeß aufgebracht werden.

7. Verfahren nach Anspruch 5 oder 6, **dadurch gekennzeichnet,** daß als Lanthanid-Arsenid Erbium-Arsenid verwendet wird.

8. Verfahren nach einem der Ansprüche 5 bis 7, **dadurch gekennzeichnet,** daß beim ersten Ätzschritt eine alkalische Ätze mit Ammoniumhydroxyd und Wasserstoffsuperoxyd verwendet wird.

9. Verfahren nach Anspruch 7, **dadurch gekennzeichnet,** daß bei dem zweiten Ätzschritt Salzsäure verwendet wird.

10. Verfahren nach einem der vorstehenden Ansprüche, **dadurch gekennzeichnet,** daß die metallischen Kontaktstreifen durch Aufdampfen von Nickel und Gold gebildet werden.

## Claims

1. Field effect transistor with a layer sequence of a semi-insulating substrate, of an epitactically grown undoped gallium-aluminum-arsenide or gallium-arsenide buffer layer and of a channel layer of a well-conducting doped gallium-arsenide, on which for the source electrode and drain electrode there are applied gallium-arsenide cover layer strips metallically coated in lateral spacing from one another, between which as gate electrode there is present a metal strip applied directly to the channel layer, characterized in that between the cannel layer (3) and the gallium-arsenide cover layer strips (10), the source and the drain electrodes (7, 8) in each case a contact-mediating interlayer (9) of lanthanide-arsenide is provided, and that the metal coatings of the course and drain electrode (7, 8) are formed by a vaporized-on nonalloyed metal layer (11).

2. Field effect transistor according to Claim 1, characterized in that the vaporized-on nonalloyed metal layer consists of a nickel layer (11).

3. Field effect transistor according to Claim 2, characterized in that the nickel layer (11) is coated with a vaporized-on gold layer, to which there are fastened the contact wires (12, 13) for the source and drain electrode (7, 8).

4. Field effect transistor according to one of the Claims 1 - 3, characterized in that the lanthanide layer (9) is an erbium-arsenide layer or ytterbium-arsenide layer.

5. Process for the production of a field effect transistor, in which onto a gallium-arsenide plate serving as substrate there is epitactically applied a buffer layer of gallium-arsenide or gallium-aluminum-arsenide and thereupon epitactically a conducting channel layer of gallium arsenide doped with silicon, before for the source and drain electrode a cover layer ist generated of well-conducting, doped gallium-arsenide with a structured metal vaporizing-on, in which process the cover layer between the source and the drain electrode is etched off up to the channel layer before the application of the gate electrode, characterized in that after the growing of the channel layer and before the application of the cover layer, there ist generated a monocrystalline, epitactic lanthanide-arsenide layer as contact-mediating layer, that onto the cover layer there are vaporized metal contact strips as course and drain contact, that in a first etching step the cover layer between the source and drain contacts is etched away and in a second etching step, the lanthanide-arsenide layer between the source and drain contacts is etched away.

6. Process according to Claim 5, characterized in that the arsenide layers are applied in a molecular-jet epitaxy installation and the metal contact strips for the source and drain electrodes are applied without alloying process in a metal vaporizing installation.

7. Process according to Claim 5 or 6, characterized in that as lanthanide arsenide there is used erbium arsenide.

8. Process according to Claim 5 to 7, characterized in that, in the first etching step, there is used an alkaline etch with ammonium hydroxide and hydrogen superoxide.

9. Process according to Claim 7, characterized in that, in the second etching step, hydrochloric acid is used.

10. Process according to one of the Claims 5 - 9, characterized in that the metal contact strips are formed by vaporizing-on of nickel and gold.

## Revendications

1. Transistor à effet de champ, comprenant une suite de couches formée par un substrat sémi-isolant, une couche de tampon non-dopée épitaxiale, à arséniure de gallium-aluminium ou à arséniure de gallium, et par une couche de vole à un arséniure de gallium dopé à bonne conductivité, sur laquelle des bandes de couche de recouvrement à arséniure de gallium, couvertes d'une couche métallique, sont déposées à une distance latérale l'une de l'autre pour l'électrode de source et l'électrode de drain, une bande métallique étant disposée y entre comme grille déposée directement sur ladite couche de voie, **caractérisé en** ce qu'une couche intermédiaire (9) respective en un arséniure de lanthanides, qui établit un contact, est disposée entre ladite couche de voie (3) et lesdites bandes de couche de recouvrement à arséniure de gallium (10), et en ce que les recouvrements métalliques des électrodes de source et de drain (7, 8) sont formés par une couche métallisée sous vide et non-alliée (11).

2. Transistor à effet de champ son la revendication 1, **caractérisé en** ce que ladite couche non-alliée et métallisée sous vide est formée par une couche au nickel (11)

3. Transistor à effet de champ selon la revendication 2, **caractérisé en** ce que ladite couche au nickel (11) est recouverte par une couche d'or métallisée sous vide, à laquelle sont fixés les conducteurs de contact (12, 13) pour les électrodes de source et de drain.

4. Transistor à effet de champ selon une quelconque des revendications précédentes, **caractérisé en** ce que ladite couche de lanthanides (9) est une couche à arséniure d'erbium ou à arséniure d'ytterbium.

5. Procédé de fabrication d'un transistor à effet de champ dans lequel une couche de tampon à arséniure de gallium ou arséniure de gallium-aluminium est épitaxialement déposée sur une galette à arséniure de gallium, qui sert en tant que substrat, et ensuite est déposée épitaxialement une couche de vole conductrice à arséniure de gallium dopé en silicium, avant qu'une couche de recouvrement à arséniure de gallium à arséniure de gallium dopé à bonne conductivité est crée pour les électrodes de source et de drain, par vole de métallisation sous vide structurée, ladite couche de recouvrement étant gravée entre lesdites électrodes de source et de drain jusqu'à ladite couche de voie avant le dépôt de la grille, **caractérisé en** ce qu'après l'épitaxie de ladite couche de voie et avant le dépôt de ladite couche de recouvrement une couche épitaxiale monocristalline à arséniure de lanthanides est produite comme la couche qui établit un contact, que des bandes de contact métalliques sont métallisées sous vide sur ladite couche de recouvrement comme les contact de source et de drain, que par une première étape de morsure ladite couche de recouvrement est enlevée par morsure entre lesdits contacts de source et de drain, pendant que par une deuxième étape de morsure ladite couche à arséniure de lanthanides est enlevée par morsure entre lesdits contacts de source et de drain.

6. Procédé selon la revendication 5, **caractérisé en** ce que lesdites couches à arséniure sont déposées dans un arrangement d'épitaxie à rayon moléculaire pendant que lesdites bandes de contact métalliques pour lesdites électrodes de source et de drain sont déposées sans alliage dans un arrangement de métallisation sous vide.

7. Procédé selon la revendication 5 ou 6, **caractérisé en** ce que l'arséniure d'erbium est utilisé comme ladite couche de lanthanides.

8. Procédé selon une quelconque des revendications 5 à 7, **caractérisé en** ce qu'un agent caustique alcalin à hydroxyde d'ammonium et à peroxyde d'hydrogène est utilisé dans la première étape de morsure.

9. Procédé selon une quelconque des revendications 5 à 7, **caractérisé en** ce que de l'acide chlorhydrique est utilisé dans la deuxième étape de morsure.

10. Procédé selon une quelconque des revendications précédentes, **caractérisé en** ce que lesdites bandes métalliques de contact sont formées par métallisation sous vide de nickel et de l'or.
